# EUROPEAN PATENT SPECIFICATION

(11) **EP 3 453 059 B1**
(45) Date of publication and mention of the grant of the patent: **28.10.2020**
(21) Application number: 16720437.9
(22) Date of filing: 04.05.2016
(51) Int. Cl.: H01L 51/00, H01L 51/42, H01L 27/30

(54) **METHOD FOR FABRICATING A SOLAR MODULE**
VERFAHREN ZUR HERSTELLUNG EINES SOLARMODULS
PROCÉDÉ DE FABRICATION D'UN MODULE SOLAIRE

(43) Date of publication of application: 13.03.2019
(73) Proprietor: Bayerisches Zentrum für Angewandte Energieforschung e. V. (ZAE Bayern), 97074 Würzburg (DE)
(72) Inventor: SPYROPOULOS, George, New York, NY 10027 (US); EGELHAAF, Hans-Joachim, 90403 Nürnberg (DE); BRABEC, Christoph J., 90403 Nürnberg (DE); AMERI, Tayebeh, 81477 München (DE); SALVADOR, Michael, 50823 Köln (DE)
(74) Representative: Dr. Gassner & Partner mbB
(86) International application number: PCT/EP2016/060089
(87) International publication number: WO 2017/190787

(56) References cited:
- WO-A1-2015/033088
- WO-A1-2015/085441
- US-A1- 2010 276 071
- J. HUANG ET AL: "A Semi-transparent Plastic Solar Cell Fabricated by a Lamination Process", ADVANCED MATERIALS, vol. 20, no. 3, 4 February 2008 (2008-02-04), pages 415-419, XP055338608, DE ISSN: 0935-9648, DOI: 10.1002/adma.200701101 cited in the application

## Description

The invention concerns a method for fabricating a solar module having a plurality of solar cells, a sub-laminate for fabricating the solar module and a solar module.

WO 2015/033088 A1 discloses a method for fabricating a solar module having a plurality of solar cells, the method comprising: Forming a laminate having a first carrier layer, a first electrode layer, a photoactive layer, a second electrode layer, and a transparent second carrier layer, the photoactive layer being disposed between the first and second electrode layers, the first electrode layer being superimposed by the first carrier layer, and the second electrode layer being superimposed by the second carrier layer so that the first and the second carrier layers form outside surfaces of the laminate.

Huang, J., Li, G., Yang, Y.: A Semi-transparent Plastic Solar Cell Fabricated by a Lamination Process, Adv. Mater., 20, 415-419 (2008) discloses a method for fabricating a plastic solar cell. The method comprises the steps of forming a laminate having a first carrier layer, a first electrode layer, a photoactive layer, a second electrode layer, and a transparent second carrier layer, the photoactive layer being disposed between the first and the second electrode layers, the first electrode layer being superimposed by the first carrier layer, and the second electrode layer being superimposed by the second carrier layer so that the first and the second carrier layers form outside surfaces of the laminate.

By the known method it is possible to produce a solar cell. A solar cell as such is not very effective. In order to increase the effectiveness it is generally known to combine a plurality of solar cells to form a solar module. In the solar module the solar cells are interconnected by electrically conducting paths.

The object underlying the present invention is to provide a method by which a solar module having a plurality of solar cells can be fabricated easily and at low cost. A further object of the invention is to provide a sub-laminate for fabricating the solar module as well as a solar module which can easily be manufactured at low cost.

This object is solved by the features of claim 1. Embodiments of the invention result from the features of claims 2 to 14.

According to the invention a method for fabricating a solar module having a plurality of solar cells is proposed, the method comprising:
Forming a laminate having a first carrier layer, a first electrode layer, a photoactive layer, a second electrode layer, and a transparent second carrier layer, the photoactive layer being disposed between the first and second electrode layers, the first electrode layer being superimposed by the first carrier layer, and the second electrode layer being superimposed by the second carrier layer so that the first and the second carrier layers form outside surfaces of the laminate, and manufacturing, after the step of forming the laminate, a first pattern of electrically isolating paths within the second electrode layer by means of a laser.

The proposed solar module may be in particular a thin-film solar module. The proposed solar module can be produced at low cost by a relative simple lamination process. The second electrode layer is superimposed by a transparent second carrier layer which forms an outside surface of the laminate. According to the invention, it is provided that a first pattern of isolating paths is formed within the second electrode layer after the laminate has been formed. Thereby, the manufacture of the first structure can easily be carried out. The first structure can be easily aligned with a second pattern within the laminate which may be produced in one of the layers during the lamination process. By the proposed method a geometric fill factor of more than 90% and an power conversion efficiency of up to 5,3% for organic photoactive layers, and of up to 9,8% for perovskite photoactive layers can be achieved.

The term "transparent" is understood in the context of the present invention to be permeable for electromagnetic radiation, in particular light.

The second electrode layer is advantageously embodied to have a lower laser ablation threshold compared to the superimposed transparent second carrier layer and the underlying photoactive layer. This makes it possible to pattern or structure, respectively, the second electrode layer in particular by in-depth-resolved post patterning-technique while leaving the sandwiching second carrier layer and the photoactive layer essentially unaffected. By means of the laser the intercalated second electrode layer is destroyed along a predetermined path. It turned out that thereby electrically isolating paths may be produced, the electrically isolating properties of which are sufficient to manufacture a solar module.

In the context of the present invention the second electrode layer has a first electrical conductivity. The electrical isolating path has a second electrical conductivity which is lower than the first electrical conductivity. The first electrical conductivity of the second electrode is usually more than 1.000 S/m, in particular more than 10.000 S/m. The second electrical conductivity of the isolating path is usually less than 1.000 S/m, in particular less than 100 S/m.

According to an embodiment of the invention the second electrode layer is formed of a electrically conducting particle layer and an electrically conducting adhesive layer. The electrically conducting particle layer is advantageously in contact with the second carrier layer. The electrically conducting adhesive layer is advantageously in contact with the electrically conducting particle layer. The electrically conducting particles are advantageously fixed by the electrically conducting adhesive layer.

According to an embodiment of the invention the electrically conducting adhesive layer is made of an adhesive which may be activated thermally, by pressure or radiation. The electrically conducting adhesive layer advantageously has an electrical conductivity of at least 3 S/m. The electrically conducting adhesive layer may comprise one or more of the following components: poly(ethylenedioxythiophene) (= PEDOT):poly(styrenesulfonate) (= PSS) doped with a sugar, e. g. D-sorbitol or volemitol. The electrically conducting adhesive layer may also be formed by a resin doped with electrically conducting particles. The proposed adhesive makes it possible to manufacture the laminate by roll-lamination of two sub-laminates.

According to a further embodiment of the invention the first electrode layer may be formed of one of the following materials: nanowires, indium tin oxide (= ITO), ITO/metal/ITO (= IMI), where the metal may be Ag, an Ag-Pd- or Ag-Ti-alloy, graphene, Ag-paste, highly conductive PEDOT:PSS, in particular combined with a metal grid.

The electrically conducting particles of the electrically conducting particle layer may be selected from the following group: nanowires, graphene, carbon nanotubes, metal particles. The nanowires or the metal particles may be made of one of the following metals: Au, Ag, Cu. The first and/or the second carrier layer may be made of glass or a transparent polymer being selected from the following group: PET, PI, PEN.

According to a further embodiment of the invention the first electrode layer may be provided with a predetermined second pattern by means of a laser before the photoactive layer is deposited thereon. In a similar manner the photoactive layer may be provided with a predetermined third pattern by means of a laser before the first electrode is deposited thereon.

According to a particular advantageous embodiment of the invention the laminate is fabricated by the following steps:
Forming a first sub-laminate having the first carrier layer, the first electrode layer, and the photoactive layer, the first electrode layer being disposed between the first carrier layer and the photoactive layer,
forming a second sub-laminate having the transparent second carrier layer, the electrically conducting particle layer and the electrically conducting adhesive layer, the electrically conducting particle layer being disposed between the second carrier layer and the electrically conducting adhesive layer,
superimposing the first sub-laminate and the second sub-laminate such that the first and the second carrier layers form the outside of the laminate, and
exerting a pressure upon a stack of layers formed by the superimposed first and second sub-laminates thereby forming the laminate where the first and the second sub-laminates are glued by means of the electrically conducting adhesive layer.

The forming of the first and the second sub-laminate has the advantage that the processing of the second electrode can be decoupled from the rest of the fabrication process. This allows for easily switching between a manufacture of single cells, tandem cells or modules. Further, the second sub-laminate functions as a barrier, e. g. against moisture, and thus enables an encapsulation at the earliest possible stage of manufacture.

The exerting of a pressure upon the stack of the layers may be advantageously carried out by a roll lamination process. Such process is simple and fast. An exact alignment of the first sub-laminate with the second sub-laminate is not necessary as the first pattern is formed after gluing the first with the second sub-laminate.

According to a further embodiment of the invention the stack of layers is heated up to a temperature in the range of 50 °C to 150 °C during the step of exerting a pressure. Thereby a curing of the electrically conducting adhesive can be accelerated.

Further, following the step of forming the first pattern within the second electrode, the laminate may be heated up to a temperature in the range of 50 °C to 150 °C.

A sub-laminate for fabricating a solar module may comprise the following layers being superimposed in the order a) to c):
a) A second carrier layer made of a transparent material,
b) an electrically conducting particle layer, and
c) an electrically conducting adhesive layer.

The proposed sub-laminate is a product which may be combined with different kinds of further sub-laminates, e. g. by roll-lamination. The sub-laminate provides advantageously the electrically conducting particle layer which may be patterned by means of a laser when the sub-laminate forms part of a laminate. As the carrier layer is made of a transparent material a laser beam may pass through the transparent polymer without destroying it. By the laser beam there can be selectively destroyed the electrically conducting particle layer along predetermined paths or sections. The proposed sub-laminate may be used for fabricating solar modules, touch screens or the like. - The electrically conducting adhesive layer may be covered by a protective cover layer which may be peeled off before attaching the sub-laminate to another laminate. The protective cover layer may be made e. g. of waxed paper or the like.

The electrically conducting adhesive layer may be made of an adhesive adapted to be activated thermally by pressure or radiation. The electrically conducting adhesive layer may have electrical conductivity of at least 3 S/m. Preferably, the electrically conducting adhesive layer has an electrical conductivity of at least 4 S/m. The electrically conducting adhesive layer may comprise one or more of the following components: PEDOT:PSS doped with a sugar, e. g. D-sorbitol or volemitol. The electrically conducting adhesive layer may also be formed of a resin doped with electrically conducting particles. The electrically conducting particles may be formed by Ag, Cu, Au or the like.

The electrically conducting particles of the electrically conducting particle layer may be selected from the following group: nanowires, graphene, carbon nanotubes, metal particles. The nanowires or the metal particles are preferably made of one of the following metals: Au, Ag, Cu.

A solar module may comprise the following layers being superimposed in the order a) to d) is proposed:
a) A first carrier layer,
b) a first electrode layer,
c) a photoactive layer,
d) the sub-laminate according to the invention, the electrically conducting adhesive layer being in contact with the photoactive layer.

The proposed solar module may be manufactured easily and at low cost. It provides a large geometrical fill factor of more than 90%. The solar cell is semitransparent and flexible. It is robust against environmental influences.

The first electrode layer may be formed of one of the following materials: nanowires, ITO, IMI, graphene, Ag-paste, highly conductive PEDOT:PSS, in particular combined with a metal grid, metal particles. The nanowires or metal particles may be made of one of the following metals: Au, Ag, Cu.

The first and/or the second carrier layer may be made of glass or a transparent polymer being selected from the following group: PET, PI, PEN.

In the solar module the second electrode layer may be provided with a first pattern of isolating paths, the first electrode layer may be provided with a second pattern of electric isolating paths and the photoactive layer may be provided with a third pattern of electric isolating paths. By the electrically isolating paths there are produced a plurality of solar cells. The electrically isolating paths may be filled with a superimposed material to form connections between the solar cells and thereby to form the solar module.

Embodiments of the invention are described by reference to the accompanying figures.
- Fig. 1a-g: shows steps of a method for manufacturing a solar module,
- Fig. 2: shows schematically a sectional view of the solar module according to Fig. 1g,
- Fig. 3a: shows a cross-section scanning electron-microscopy (SEM) image of the solar module and
- Fig. 3b: shows a top view of the layer of nanowires after a delimitation of the transparent first carrier layer.

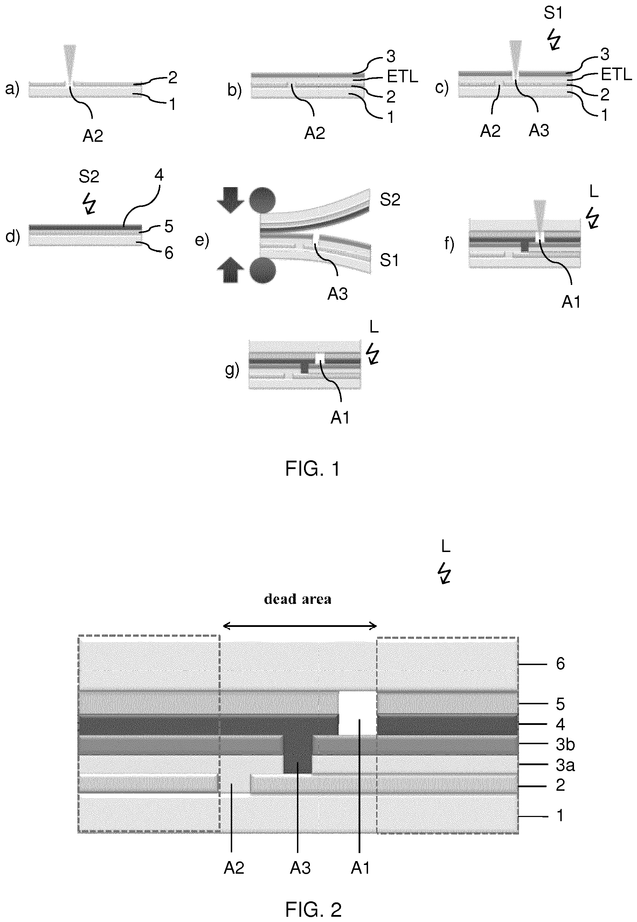

Fig. 1a shows a first and a second step of the method. A first carrier layer 1, e. g. a transparent foil made of PET, is coated in a conventional manner with a first electrode layer 2, e. g. a transparent electrode made of an IMI (= ITO/Metal /ITO) or of Indium tin oxide (= ITO)). The first electrode layer 2 is then provided by laser patterning with a second pattern A2 (second step).

On top of the first electrode layer 2 there is coated as a third step a layer made of ZnO nanoparticles. The layer had a thickness of around 30 nm. The layer 3a was dried at a temperature of 80 °C for five minutes. The aforementioned layer 3a forms an electron transfer layer (= ETL).

In a fourth step of the method there is coated a photoactive layer 3b on top of the ETL 3a (see Fig. 1b). As photoactive layer 3b there was used a medium band gap conjugated polymer PBTZT-stat-BDTT-8 blended with phenyl-C61-butyric acid methyl ester (PC[60]BM). In a fifth step of the method there is provided a third pattern A3 within the photoactive layer 3b by use of a laser. Steps one to five of the method result in a first sub-laminate S1 (see Fig. 1c). - The ETL 3a is considered in this example to be a sub-layer of the photoactive layer 3b.

The method further comprises the manufacture of a second sub-laminate S2. As a second carrier layer 6 there is used e. g. a foil made of transparent PET which is coated by a layer of nanowires 5, in particular Ag-nanowires (sixth step of the method). The layer of nanowires 5 was made of a water-based solution which was dried at around 100 °C for 3 to 5 minutes. The layer of nanowires 5 has a thickness in the range of 50 to 200 nm, preferably 80 to 120 nm. On top of the layer of nanowires 5 there is coated an electrically conducting adhesive layer 4 containing e. g. PEDOT:PSS and D-sorbitol which has an electrically conductivity of around 8,5 S/m (seventh step of the method).

In an eight step of the method the first sub-laminate S1 is then glued with the second sub-laminate S2 by a roll-lamination process as shown in Fig. 1e. When forming the laminate L the electrically conducting adhesive layer 4 is pressed into the grooves formed by the third pattern A3 providing an electrical contact between the photoactive layer 3b and the electrically conducting particle layer, in particular between the ETL 3a and the layer of nanowires 5. The outside of the laminate L is formed by the carrier layers 1 and 6. The roll-lamination process is carried out at a temperature in the range of 60 °C to 150 °C. The laminate L is afterwards annealed at a temperature in the range of 60 °C to 150 °C for 10 minutes.

In a ninth step of the method there is manufactured a first pattern A1 within the layer of nanowires 5 by in-depth laser ablation. Thereby there is produced an isolating path within the first electrode layer 2 made of the layer of nanowires 5 and the layer of electrically conducting adhesive 4.

According to an alternative of the method the photoactive layer 3b may be made of perovskite. In this case a first carrier layer 1 made of PET or glass is spin-coated with an LT-NiO layer at a speed of 3.000 to 6.000 rpm and annealed at 140 °C for 5 to 15 minutes in air. A dimethylformamide (DMF)-perovskite precursor solution is made by adding PbI₂ and CH₃NH₃I powders with a molar ratio of approximately 1:1 and a concentration of 40 wt% and 20 wt% to a vial and mixed with anhydrous DMF. The precursor solution is then stirred for 10 to 40 minutes at 40 to 70 °C and filtered with 0.45 µm PTFE syringe filter prior to deposition. The precursor solution is then spin-coated in an inert atmosphere at room temperature using 2.000 to 5.000 rpm for 10 to 40 seconds. During the last 5 seconds of the spin-coating process, the layer is treated with chlorobenzene drop-casting. The coated first carrier layer 1 is then dried on a hot plate at 80 °C to 120 °C for 5 to 15 minutes. After the deposition of the perovskite a compact 60 nm thick layer of PC₆₀BM is spin-coated. A 2 wt% solution of PC₆₀BM in chlorobenzene is then spin-coated. Afterwards a ZnO film forming the ETL 3a is spin-coated at 1.000 to 4.000 rpm and annealed for 2 to 10 minutes at 60 °C to 120 °C. Polyethylenimine (= PEI) is spin-coated at 500 to 3.000 rpm and annealed at 60 °C to 120 °C for 2 to 10 minutes. - The connection with the second sub-laminate S2 is carried out at 40 to 70 °C in inert atmosphere by roll-lamination.

The proposed method for manufacturing solar modules with the laminated second electrode 4, 5 involves a depth-resolved post-patterning technique. The manufacture is fully roll-to-roll compatible due to the high processing speed of the laser patterning approach (up to 4 m s⁻¹) and solution processing of all functional layers. The method according to the invention includes layer coating and laser patterning, e. g. under ambient atmospheric conditions. Generally, in order to achieve electrical series interconnection between individual solar cells in a solar module, three patterns A1 to A3 are manufactured (see Fig. 2). There may be used a femtosecond-laser patterning with optimized ablation thresholds for each pattern A1 to A3 in order to achieve high spatial resolution and a high geometrical fill factor (= GFF). After electrical separation of the first electrode layer 2 by the second pattern A2, the ETL 3a as well as the photoactive layer 3b are successively coated. During the fifth step the photoactive layer 3b and the ETL 3a are ablated to form the third pattern A3 by applying a laser fluence lower than the ablation threshold of the first electrode layer 2. In a separate process, the layer of nanowires 5 and the electrically conducting adhesive layer 4 are consecutively coated on the second carrier layer 6 to form the second sub-laminate S2, which is then assembled on top of the photoactive layer 3b of the first sub-laminate S1 by passing through a pre-heated roll-laminator. Afterwards the second electrode 4, 5 included in the fully laminated stack is patterned using depth-resolved laser patterning through the transparent second carrier layer 6. This step allows to selectively structure the second electrode 4, 5 and, by carefully tuning the laser fluence, neither damaging the second carrier layer 6 nor the photoactive layer 3b. This technique becomes viable as the second electrode layer, in particular the layer of nanowires 5, exhibits an ablation threshold lower than the value for the materials of which the second carrier layer 6 and the photoactive layer 3b are made.

Fig. 2 shows schematically a cross section through a solar module fabricated in accordance with the present invention. A first carrier layer 1 is e. g. made of a IMI-based flexible PET foil. The first electrode layer 2 is superimposed by a photoactive layer 3b. The photoactive layer 3b is connected by the electrically conducting adhesive layer 4 with the layer of nanowires 5. The layer of nanowires 5 is superimposed by the second carrier layer 6 which may be made of transparent PET.

The first pattern A1, the second pattern A2 and the third pattern A3 can be provided within a narrow lateral area, the so-called "dead area" (see Fig. 2). Within the dead area a production of solar energy is not possible. The GFF which is in percent the total remaining area outside the dead areas can be set to values more than 90% by the proposed method.

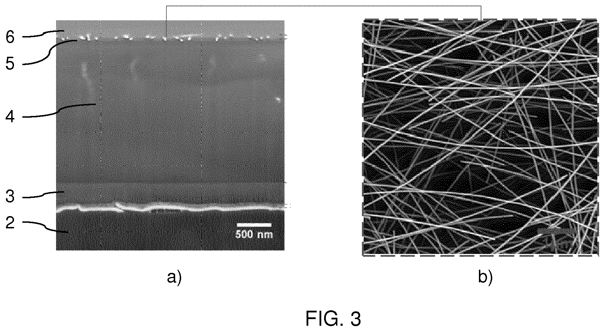

Fig. 3a shows a cross-section scanning electron-microscopy image of the solar module. The layer of nanowires 5 appears as bright spots in the SEM image.

Fig. 3b shows a top view of the layer of nanowires 5. The nanowires form a mesh where the nanowires are in point or line contact.

### List of reference signs

- 1: first carrier layer
- 2: first electrode layer
- 3a: ETL
- 3b: photoactive layer
- 4: electrically conducting adhesive layer
- 5: layer of nanowires
- 6: second carrier layer

- A1: first pattern
- A2: second pattern
- A3: third pattern
- L: laminate
- S1: first sub-laminate
- S2: second sub-laminate

## Claims

1. A method for fabricating a solar module having a plurality of solar cells, the method comprising:
Forming a laminate (L) having a first carrier layer (1), a first electrode layer (2), a photoactive layer (3b), a second electrode layer, and a transparent second carrier layer (6), the photoactive layer (3b) being disposed between the first (2) and second electrode layers, the first electrode layer (2) being superimposed by the first carrier layer (1), and the second electrode layer being superimposed by the second carrier layer (6) so that the first (1) and the second carrier layers (6) form outside surfaces of the laminate (L), and
manufacturing, after the step of forming the laminate (L), a first pattern (P1) of electrically isolating paths within the second electrode layer by means of a laser.

2. The method according to claim 1, wherein the second electrode layer is formed of an electrically conducting particle layer (5) and an electrically conducting adhesive layer (4).

3. The method according to one of the preceding claims, wherein the electrically conducting adhesive layer (4) is made of an adhesive which is thermally activated or activated by pressure or radiation.

4. The method according to one of the preceding claims, wherein the electrically conducting adhesive layer (4) has an electrical conductivity of at least 3 S/m.

5. The method according to one of the preceding claims, wherein the electrically conducting adhesive layer (4) comprises one or more of the following components: poly(ethylenedioxythiophene) (= PEDOT):poly(styrenesulfonate) (= PSS) doped with a sugar, or a resin doped with electrically conducting particles.

6. The method according to one of the preceding claims, wherein the first electrode layer (2) is formed of one or more of the following materials: nanowires, ITO, IMI, graphene, Ag-paste, highly conductive PEDOT:PSS, in particular combined with a metal grid.

7. The method according to one of the preceding claims, wherein the electrically conducting particles of the electrically conducting particle layer are selected from the following group: nanowires, graphene, carbon nanotubes, metal particles.

8. The method according to one of the preceding claims, wherein the nanowires or the metal particles are made of one of the following metals: Au, Ag, Cu.

9. The method according to one of the preceding claims, wherein the first (1) and/or second carrier layer (6) is made of glass or a transparent polymer being selected from the following group: PET, PI, PEN.

10. The method according to one of the preceding claims, wherein the first electrode layer (2) is provided with a predetermined second pattern (A2) by means of a laser before the photoactive layer (3b) is deposited thereon.

11. The method according to one of the preceding claims, wherein the photoactive layer (3b) is provided with a predetermined third pattern (A3) by means of a laser before the second electrode layer is deposited thereon.

12. The method according to one of the preceding claims, wherein the laminate (L) is fabricated by the following steps:
Forming a first sub-laminate (S1) having the first carrier layer (1), the first electrode layer (2), and the photoactive layer (3b), the first electrode layer (2) being disposed between the first carrier layer (1) and the photoactive layer (3b),
forming a second sub-laminate (S2) having the transparent second carrier layer (6), the electrically conducting particle layer and the electrically conducting adhesive layer (4), the electrically conducting particle layer being disposed between the second carrier layer (6) and the electrically conducting adhesive layer (4),
superimposing the first sub-laminate (S1) and the second sub-laminate (S2) such that the first (1) and the second carrier layers (6) form the outside of the laminate (L), and
exerting a pressure upon a stack of layers formed by the superimposed first (S1) and second sub-laminates (S2) thereby forming the laminate (L) where the first (S1) and the second sub-laminates (S2) are glued by means of the electrically conducting adhesive layer (4).

13. The method according to claim 12, wherein the stack of layers is heated up to a temperature in the range of 50 °C to 150 °C during the step of exerting a pressure.

14. The method according to one of claims 12 or 13, wherein, following the step of forming the first pattern (A1) within the layer of nanowires (5), the laminate (L) is heated up to a temperature in the range of 50 °C to 150 °C.

## Patentansprüche

1. Verfahren zur Herstellung eines Solarmoduls mit einer Vielzahl von Solarzellen, wobei das Verfahren umfasst:
Bilden eines Laminats (L) mit einer ersten Trägerschicht (1), einer ersten Elektrodenschicht (2), einer photoaktiven Schicht (3b), einer zweiten Elektrodenschicht und einer transparenten zweiten Trägerschicht (6), wobei die photoaktive Schicht (3b) zwischen der ersten (2) und der zweiten Elektrodenschicht angeordnet ist, wobei die erste Elektrodenschicht (2) von der ersten Trägerschicht (1) überlagert wird und die zweite Elektrodenschicht von der zweiten Trägerschicht (6) überlagert wird, so dass die erste (1) und die zweite Trägerschicht (6) Außenflächen des Laminats (L) bilden, und
Herstellen, nach dem Schritt der Herstellung des Laminats (L), eines ersten Musters (P1) elektrisch isolierender Pfade innerhalb der zweiten Elektrodenschicht mit Hilfe eines Lasers.

2. Verfahren nach Anspruch 1, wobei die zweite Elektrodenschicht aus einer elektrisch leitenden Partikelschicht (5) und einer elektrisch leitenden Haftschicht (4) gebildet wird.

3. Verfahren nach einem der vorhergehenden Ansprüche, wobei die elektrisch leitende Klebeschicht (4) aus einem Klebstoff besteht, der thermisch oder durch Druck oder Strahlung aktiviert wird.

4. Verfahren nach einem der vorhergehenden Ansprüche, wobei die elektrisch leitende Klebstoffschicht (4) eine elektrische Leitfähigkeit von mindestens 3 S/m aufweist.

5. Verfahren nach einem der vorhergehenden Ansprüche, wobei die elektrisch leitende Klebstoffschicht (4) eine oder mehrere der folgenden Komponenten umfasst: Poly(ethylendioxythiophen) (= PEDOT):Poly(styrolsulfonat) (= PSS), dotiert mit einem Zucker, oder ein Harz, dotiert mit elektrisch leitenden Partikeln.

6. Verfahren nach einem der vorstehenden Ansprüche, wobei die erste Elektrodenschicht (2) aus einem oder mehreren der folgenden Materialien gebildet wird: Nanodrähte, ITO, IMI, Graphen, Ag-Paste, hochleitendes PEDOT:PSS, insbesondere in Kombination mit einem Metallgitter.

7. Verfahren nach einem der vorstehenden Ansprüche, wobei die elektrisch leitenden Partikel der elektrisch leitenden Partikelschicht aus der folgenden Gruppe ausgewählt werden: Nanodrähte, Graphen, Kohlenstoff-Nanoröhren, Metallpartikel.

8. Verfahren nach einem der vorhergehenden Ansprüche, bei dem die Nanodrähte oder die Metallpartikel aus einem der folgenden Metalle hergestellt werden: Nanodrähte, Graphen, Kohlenstoff-Nanoröhren, Metallpartikel: Au, Ag, Cu.

9. Verfahren nach einem der vorhergehenden Ansprüche, wobei die erste (1) und/oder zweite Trägerschicht (6) aus Glas oder einem transparenten Polymer hergestellt ist, das aus der folgenden Gruppe ausgewählt ist: Au, Ag, Cu: PET, PI, PEN.

10. Verfahren nach einem der vorhergehenden Ansprüche, bei dem die erste Elektrodenschicht (2) mit Hilfe eines Lasers mit einem vorbestimmten zweiten Muster (A2) versehen wird, bevor die photoaktive Schicht (3b) darauf abgeschieden wird.

11. Verfahren nach einem der vorhergehenden Ansprüche, bei dem die photoaktive Schicht (3b) mit einem vorbestimmten dritten Muster (A3) mit Hilfe eines Lasers versehen wird, bevor die zweite Elektrodenschicht darauf abgeschieden wird.

12. Verfahren nach einem der vorhergehenden Ansprüche, bei dem das Laminat (L) durch die folgenden Schritte hergestellt wird:
Bilden eines ersten Teil-Laminats (S1) mit der ersten Trägerschicht (1), der ersten Elektrodenschicht (2) und der photoaktiven Schicht (3b), wobei die erste Elektrodenschicht (2) zwischen der ersten Trägerschicht (1) und der photoaktiven Schicht (3b) angeordnet ist,
Bilden eines zweiten Sub-Laminats (S2) mit der transparenten zweiten Trägerschicht (6), der elektrisch leitenden Partikelschicht und der elektrisch leitenden Haftschicht (4), wobei die elektrisch leitende Partikelschicht zwischen der zweiten Trägerschicht (6) und der elektrisch leitenden Haftschicht (4) angeordnet ist,
Übereinanderlegen des ersten Teil-Laminats (S1) und des zweiten Teil-Laminats (S2), so dass die erste (1) und die zweite Trägerschicht (6) die Außenseite des Laminats (L) bilden, und
Ausüben von Druck auf einen Stapel von Schichten, der durch die übereinanderliegenden ersten (S1) und zweiten Teilschichten (S2) gebildet wird, wodurch das Laminat (L) gebildet wird, wobei die ersten (S1) und zweiten Teilschichten (S2) mittels der elektrisch leitenden Klebeschicht (4) verklebt werden.

13. Verfahren nach Anspruch 12, wobei der Schichtstapel während des Schritts des Ausübens von Druck auf eine Temperatur im Bereich von 50 °C bis 150 °C erhitzt wird.

14. Verfahren nach einem der Ansprüche 12 oder 13, wobei nach dem Schritt des Ausbildens des ersten Musters (A1) innerhalb der Schicht aus Nanodrähten (5) das Laminat (L) auf eine Temperatur im Bereich von 50 °C bis 150 °C erhitzt wird.

## Revendications

1. Procédé de fabrication d'un module solaire ayant une pluralité de cellules solaires, le procédé comprenant :
la formation d'un stratifié (L) comportant une première couche de support (1), une première couche d'électrode (2), une couche photo-active (3b), une seconde couche d'électrode et une seconde couche de support transparente (6), la couche photo-active (3b) étant disposée entre la première (2) et la seconde couche d'électrode, la première couche d'électrode (2) étant superposée à la première couche de support (1) et la seconde couche d'électrode étant superposée à la seconde couche de support (6) pour que la première (1) et la seconde couche de support (6) forment des surfaces extérieures du stratifié (L), et
la fabrication, après l'étape de formation du stratifié (L), d'un premier motif (P1) de chemins électriquement isolants à l'intérieur de la seconde couche d'électrode au moyen d'un laser.

2. Procédé selon la revendication 1, en ce que la seconde couche d'électrode est constituée d'une couche de particules électriquement conductrice (5) et d'une couche adhésive électriquement conductrice (4).

3. Procédé selon l'une des revendications précédentes, en ce que la couche adhésive électriquement conductrice (4) est réalisée en un adhésif qui est activé thermiquement ou activé par pression ou par radiation.

4. Procédé selon l'une des revendications précédentes, en ce que la couche adhésive électriquement conductrice (4) présente une conductivité électrique d'au moins 3 S/m.

5. Procédé selon l'une des revendications précédentes, en ce que la couche adhésive électriquement conductrice (4) comprend l'un ou plusieurs des composants suivants : poly(éthylènedioxythiophène) (= PEDOT):poly(styrène sulfonate) (= PSS) dopé avec un sucre, ou une résine dopée avec des particules électriquement conductrices.

6. Procédé selon l'une des revendications précédentes, en ce que la première couche d'électrode (2) est constituée de l'un ou de plusieurs des matériaux suivants : nanofils, ITO, IMI, graphène, pâte d'argent, PEDOT:PSS hautement conducteur, en particulier combiné à une grille métallique.

7. Procédé selon l'une des revendications précédentes, en ce que les particules électriquement conductrices de la couche de particules électriquement conductrice sont sélectionnées parmi le groupe suivant : nanofils, graphène, nanotubes de carbone, particules métalliques.

8. Procédé selon l'une des revendications précédentes, en ce que les nanofils ou les particules métalliques sont réalisés en l'un des métaux suivants : Au, Ag, Cu.

9. Procédé selon l'une des revendications précédentes, en ce que la première (1) et/ou la seconde couche de support (6) est réalisée en verre ou en un polymère transparent sélectionné parmi le groupe suivant : PET, PI, PEN.

10. Procédé selon l'une des revendications précédentes, en ce que la première couche d'électrode (2) comporte un deuxième motif prédéterminé (A2) au moyen d'un laser avant que la couche photo-active (3b) n'y soit déposée.

11. Procédé selon l'une des revendications précédentes, en ce que la couche photo-active (3b) comporte un troisième motif prédéterminé (A3) au moyen d'un laser avant que la seconde couche d'électrode n'y soit déposée.

12. Procédé selon l'une des revendications précédentes, en ce que le stratifié (L) est fabriqué selon les étapes suivantes :
formation d'un premier sous-stratifié (S1) comportant la première couche de support (1), la première couche d'électrode (2) et la couche photo-active (3b), la première couche d'électrode (2) étant disposée entre la première couche de support (1) et la couche photo-active (3b),
formation d'un second sous-stratifié (S2) comportant la seconde couche de support transparente (6), la couche de particules électriquement conductrice et la couche adhésive électriquement conductrice (4), la couche de particules électriquement conductrice étant disposée entre la seconde couche de support (6) et la couche adhésive électriquement conductrice (4),
superposition du premier sous-stratifié (S1) et du second sous-stratifié (S2) pour que la première (1) et la seconde couche de support (6) forment l'extérieur du stratifié (L), et
exercice d'une pression sur un empilement de couches formé par le premier (S1) et le second sous-stratifié (S2) superposés formant ainsi le stratifié (L) sur lequel le premier (S1) et le second sous-laminé (S2) sont collés au moyen de la couche adhésive électriquement conductrice (4).

13. Procédé selon la revendication 12, en ce que l'empilement de couches est chauffé jusqu'à une température dans une plage comprise entre 50 °C et 150 °C lors de l'étape consistant à exercer une pression.

14. Procédé selon l'une des revendications 12 ou 13 en ce que, après l'étape consistant à former le premier motif (A1) à l'intérieur de la couche de nanofils (5), le stratifié (L) est chauffé jusqu'à une température dans une plage comprise entre 50 °C et 150 °C.
